# EUROPEAN PATENT APPLICATION

(11) **EP 1 073 116 A2**
(43) Date of publication of application: **31.01.2001**
(21) Application number: 00305700.7
(22) Date of filing: 06.07.2000
(51) Int. Cl.: H01L 23/495

(54) **Lead frame and semiconductor device**

(30) Priority: 09.07.1999 JP 19540199
(71) Applicant: SHINKO ELECTRIC INDUSTRIES CO. LTD., Nagano-shi, Nagano 380-0921 (JP)
(72) Inventor: Negishi, Katsuyuki, Shinko Electric Ind. Co. Ltd., Nagano-shi, Nagano-shi 380-0921 (JP)
(74) Representative: Rackham, Stephen Neil

(57) **Abstract**

A lead frame (1) for a resin-shielded type semiconductor device includes a die-pad section (3) on which a semiconductor element (2) is to be mounted. The die-pad section (3) comprises a base die-pad section, a plurality of slits (10) and a plurality of inserts (11). Each of the inserts (11) has a proximal end integrally connected to the base die-pad section (3) and a distal end (11b) facing into the slit (10) and having a thickness smaller than that of the base die-pad section (3). This enables the die-pad (3) to be more securely embedded into the resin shielding (9).

## Description

The present invention relates to a lead frame having an improved die-pad used for a resin-shielded type semiconductor device and a semiconductor device using the same.

In the prior art resin-shielded type semiconductor device, a semiconductor element is mounted onto a die-pad section of a lead frame and electrically connected to inner leads via wires. Thereafter, the semiconductor element and the inner leads are shielded with a resin. The shield resin is hygroscopic and moisture is liable to permeate the resin from a boundary between the resin itself and the inner leads. There is a risk that the permeated moisture may be heated and vaporized to separate the wide die-pad section from the shield resin.

To improve the adhesion between the die-pad section carrying the semiconductor element and the shield resin, various countermeasures have been proposed. For example, a plurality of dimples or through-holes can be formed by a press working in the die-pad section of the lead frame. If the dimples are formed in the die-pad section, the contact area with the shield resin increases. On the other hand, if the through-holes are formed, the shield resin is filled therein to facilitate the bonding strength. Otherwise, the die-pad section of the lead frame may be of a circular shape having a diameter smaller than that of the semiconductor device or of an X-shape. According to this structure, the shield resin can reach to the back side of the semiconductor element to increase the bonding strength.

When the plurality of dimples or through-holes are formed in the die-pad section of the lead frame by press working, however, strain may be often left in the die-pad section, which worsens the flatness thereof, by not less than 25 µm, to result in an inconvenience in mounting the semiconductor element. Accordingly, a process is necessary for correcting the strain of the die-pad section, and the production cost increases.

Also, in the semiconductor device in which the above-mentioned lead frame is used, the shield resin is liable to separate from the die-pad section due to the strain in the latter. Further, if the contour of the die-pad section of the lead frame is a small diameter circular shape or an X-shape, the heat dissipation is lowered. As described above, there is a problem in that the reliability of the semiconductor device is lowered.

An object of the present invention is to eliminate the drawbacks of the prior art and to provide a lead frame capable of improving the flatness of a die-pad section and reducing the production cost, and a semiconductor device capable of maintaining a high bonding strength between the die-pad section and a shield resin as well as a favorable heat dissipation.

According to the present invention, there is provided a lead frame adapted to be used for a resin-shielded type semiconductor device, the lead frame comprising: a die-pad section on which a semiconductor element is to be mounted, the die-pad section comprising a base die-pad section, a plurality of slits and a plurality of inserts; and each of the inserts having a proximal end integrally connected to the base die-pad section and a distal end facing the slit, the insert having a thickness smaller than that of the base die-pad section.

Two of the inserts respectively facing two of the slits which are located adjacent to each other are directed in opposite directions to each other.

The slits are formed by punching or etching the die-pad section and the inserts are formed by pressing so as to reduce the thickness thereof.

The slits are formed by punching or etching the die-pad section and the inserts are formed by etching so as to reduce the thickness thereof.

The base die-pad section has a first and a second surface, a semiconductor element is mounted on the first surface, and the insert has first and second surfaces, the thickness of the insert is reduced in such a manner that a gap is formed between the first surface of the die-pad section and the first surface of the insert but, on the other hand, the second surface of the die-pad section and the second surface of the insert are substantially on a same level.

Both the first and second surface of the base die-pad section are coated with resist films, respectively.

According to another aspect of the present invention, there is provided a semiconductor device comprising:
a lead frame comprising: a die-pad section comprising a base die-pad section, a plurality of slits and a plurality of inserts; and each of the inserts having a proximal end integrally connected to the base die-pad section and a distal end facing to the slit, the insert having a thickness smaller than that of the base die-pad section; and a plurality of inner leads;
a semiconductor element having a plurality of electrodes, the semiconductor element being mounted on the die-pad section and electrodes being electrically connected to the inner leads; and
shield resin hermetically shielding the semiconductor element and the inner leads in such a manner that the slits are filled with the shield resin and the inserts are embedded in the shield resin.

Particular embodiments in accordance with this invention will now be described with reference to the accompanying drawings; in which:-
Fig. 1(a) is a partial plan view of a die-pad section, and Fig. 1(b) is a partial sectional view taken along a line A-A in Fig. 1(a);
Fig. 2 is a partial sectional view of the die-pad section on which a semiconductor chip is mounted and shielded with resin;
Fig. 3 is a plan view of a lead frame;
Fig. 4 is a sectional view of a semiconductor device;
Figs. 5(a), 5(b) and 5(c) are a plan view, a bottom view and a partial sectional view taken along line A-A in Figs. 5(a) and 5(b), respectively, showing that a resist layer is formed on the die-pad section;
Fig. 6 is a partial sectional view of a die-pad section having an insert formed in the die-pad section by an etching treatment taken along line A-A in Figs. 5(a) and 5(b);
Fig. 7(a) is a partial plan view of a die-pad section according to another embodiment and Fig. 7(b) is a partial sectional view thereof taken along a line B-B in Fig. 7(a), respectively;
Fig. 8(a) is a partial plan view of a die-pad section according to a further embodiment and Fig. 8(b) is a partial sectional view thereof taken along a line C-C in Fig. 8(a), respectively;
Figs. 9(a) to 9(d) are views showing a comparison of the bonding strength of a die-pad section of the prior art with that of die-pad section of the present invention; and
Figs. 10(a) to 10(d) are illustrations of the slit arrangement in the die-pad section.

In the embodiments, and explanation will be given of a lead frame used for a semiconductor device of a resin shield type and of a semiconductor device in which the lead frame is used.

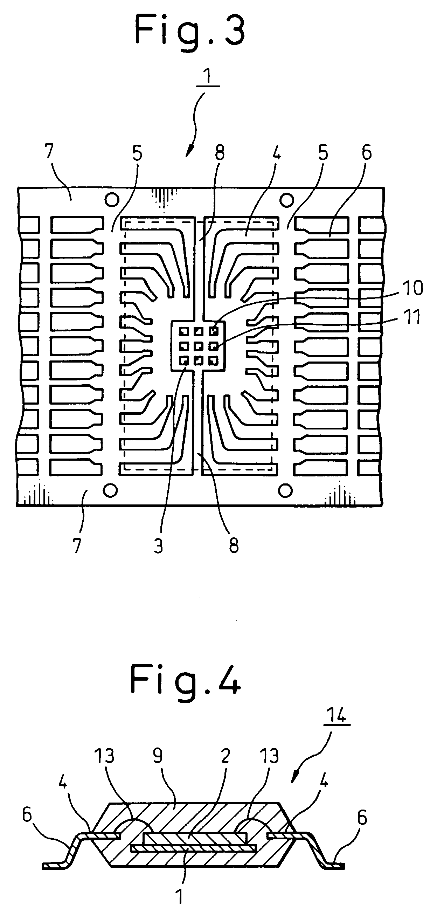

In Fig. 3, a lead frame 1 used for a semiconductor device of a resin shield type is provided with a die-pad section 3 for carrying a semiconductor element 2 thereon, inner leads 4 arranged on the periphery of the die-pad section 3 to be electrically connected to the semiconductor element 2, dam bars 5 connecting the inner leads with each other, outer leads 6 extended outward from the dam bars 5 and so on. The die-pad section 3 is held by a support bar 8 connected to a pair of rail sections 7 extending along the respective longitudinal edges of the lead frame. In this regard, in Fig. 3, a dotted line shows an area to be resin-shielded.

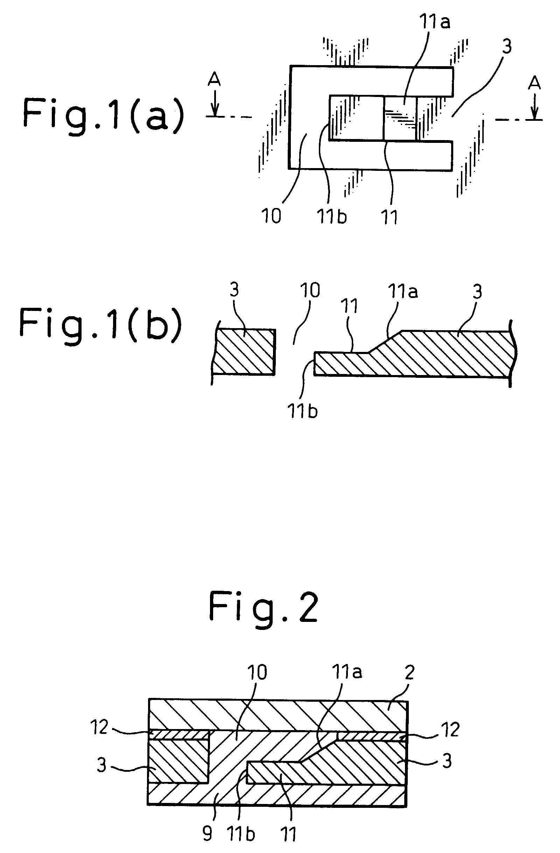

Next, the arrangement of the die-pad section 3 will be described with reference to Figs. 1(a), 1(b) and 2. The die-pad section 3 has a plurality of slits 10 in which a shield resin 9 is to be filled and a plurality of inserts 11. A proximal end 11a of the insert 11 is integrally connected to the die-pad section 3, and a distal end 11b thereof defines a free end to be inserted into and face the slit 10 and has a thickness smaller than that of the remainder of the die-pad section 3. The insert 11 is embedded in the shield resin 9 filled in the slit 10 to be anchored with each other. In Figs. 1(a) and 1(b), the plurality of slits 10 and inserts 11 are formed to have U-shaped cross-sections, by being passed through the die-pad section 3, wherein the inserts 11 have a thickness smaller than that of the remainder of the die-pad section 3.

The slit 10 and the insert 11 formed in the die-pad section 3 are made by a punching operation, and the insert 11 is then pressed, on the side on which the semiconductor element is to be mounted, to have a smaller thickness. Although the distal end 11b of the insert 11 defining a free end is deformed during the press working of the die-pad section 3, there is no risk that the die-pad section 3 itself will warp in the direction to worsen the flatness, because the insert extends toward the interior of the slit 10. According to an experiment, it was found that the warping of the die-pad section 3 could be suppressed to 3 µm or less to improve the flatness.

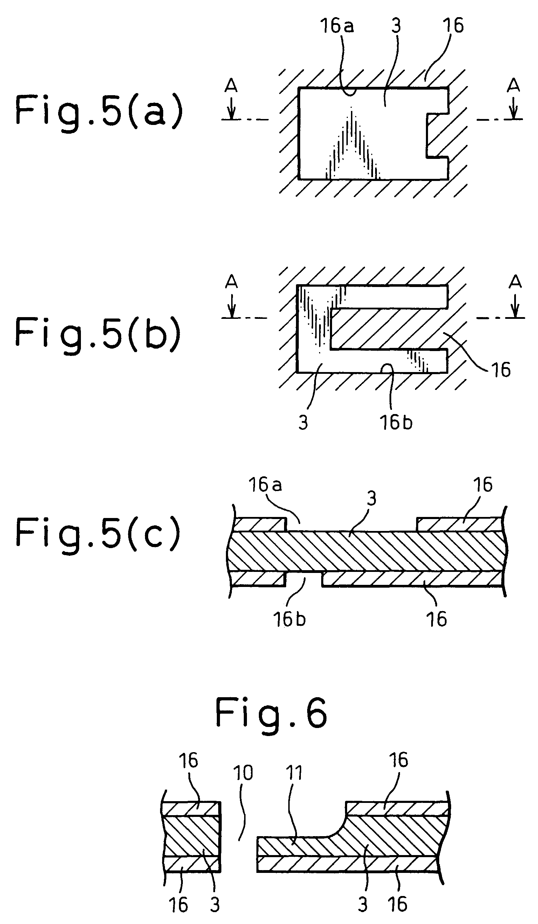

Alternatively, the insert 11 in the die-pad section 3 may be formed by a half etching method while using a mask. Concretely, as shown in Figs. 5(a) to 5(c), resist layers 16 having different patterns from each other are formed, respectively, on the side of the die-pad section 3 on which the semiconductor element is to be mounted and on the side opposite thereto. That is, as shown in Fig. 5(a), a resist layer 16 having an opening 16a including the slit 10 and the distal end 11b of the insert 11 is formed on the side of the die-pad section 3 on which the semiconductor element is to be mounted. As shown in Fig. 5(b), an opening 16b corresponding to a shape of the slit 10 is formed on the opposite side. Under such a condition, when the lead frame 1 is immersed in an etching liquid, the insert 11 shown in Fig. 6 is obtained within the slit 10 of the die-pad section 3, wherein the thickness is reduced solely on the side on which the semiconductor element is to be mounted. In this case, no strain is generated in the die-pad section 3 due to the press working, and the flatness of the die-pad section 3 is improved.

Accordingly, there is no need for a special installation for correcting the warp of the die-pad section 3, whereby the production cost of the lead frame is reduced.

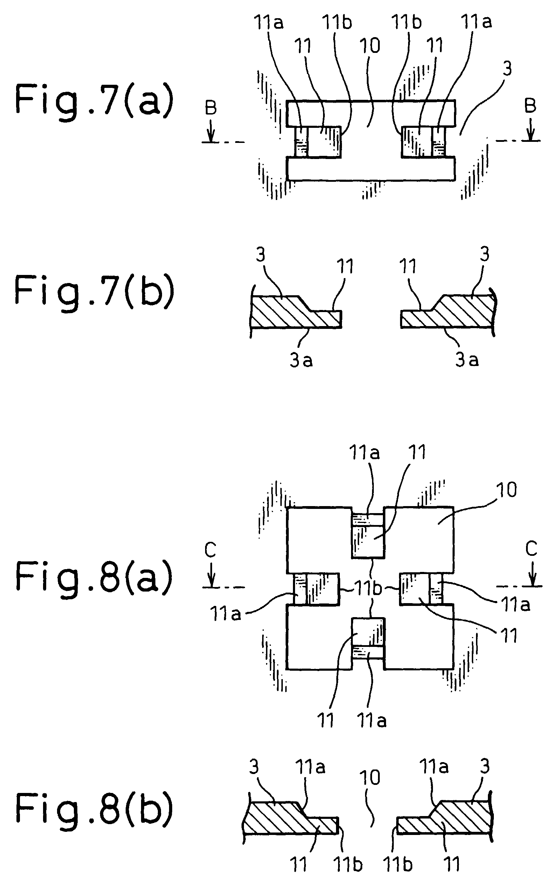

In this regard, the shape of the slit 10 should not be limited to a U-shape as described above, but may include an H-shape as shown in Figs. 7(a) and 7(b), a quadrant shape as shown in Figs. 8(a) and 8(b) or another shape.

When the semiconductor device is produced using the above-mentioned lead frame 1, the semiconductor element 2 is positioned and mounted to the die-pad section 3 of the lead frame 1 having the slits 10 and the inserts 11 formed in the die-pad section 3 as shown in Fig. 2. In this case, the die-pad section 3 is coated in advance with a silver paste 12 used as an adhesive, and the semiconductor element 2 is mounted thereon via the silver paste 12. At this time, a gap is defined between the semiconductor element 2 and the insert 11 which becomes thinner from the side on which the semiconductor element is to be mounted.

Then, electrodes of the semiconductor element 2 are electrically connected to the inner leads 4 by bonding wires 13. And, as shown in Fig. 4, the semiconductor element 2 and the inner leads 4 connected thereto are shielded with resin to complete the semiconductor device 14.

The shield resin 9 not only shields the side of the die-pad section 3 on which the semiconductor element is mounted but also flows to the back side of the die-pad section 3 as shown in Fig. 2 to fill the slit 10, whereby the insert 11 is embedded in the shield resin 9. Since the insert 11 is embedded in such a manner in the shield resin 9 which is hardened thereafter, the mechanical bonding between the die-pad section 3 and the shield resin 9 becomes firm and rigid, whereby a favorable bonding strength is maintained between the shield resin 9 and the die-pad section 3 against stress separating them from each other even in after repeated heat application during an environmental resistance test.

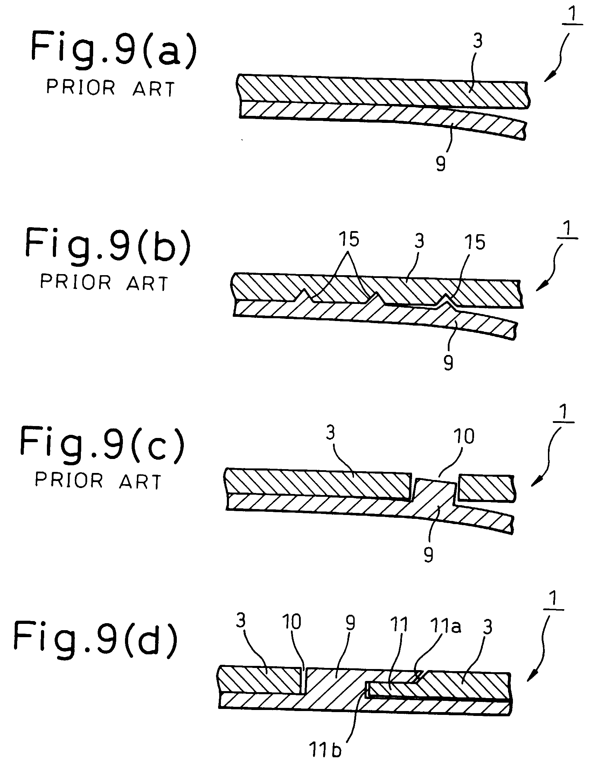

A comparison of the bonding strength of the die-pad section in the prior art with that of the die-pad section in the present invention relative to the shield resin will be more concretely explained below. As shown in Figs. 9(a) to 9(c), in the prior art, dimples 15 (Fig. 9(b)) or slits 10 (Fig. 9(c)) are provided in a flat die-pad section 3 shown in Fig. 9(a) to improve the bonding strength between the shield resin 9 and the die-pad section 3. The dimples 15 are provided for the purpose of increasing the contact area of the die-pad section 3 with the shield resin 9. Also, the slit 10 is provided for holding the shield resin therein to increase the bonding strength.

However, since these countermeasures have no function of locking the shield resin 9 when stress is applied to separate the shield resin 9 from the die-pad section 3, there is a risk of separation of the resin if the flatness of the die-pad section 3 is impaired due to the strain in the lead frame 1. In particular, this problem is more apparent if the dimples 15 are formed on the die-pad section 3 by press working.

Contrarily, according to the die-pad section 3 of the semiconductor device 14 of the present invention, since the shield resin 9 filled in the slits 10 is hardened while the inserts 11 are embedded therein, the shield resin 9 is firmly locked to the die-pad section 3, as shown in Fig. 9(a). Therefore, an improved bonding strength is maintained between the die-pad section 3 and the shield resin 9 against the thermal stress applied to the semiconductor device 14. Since a sufficient area of the die-pad section 3 is obtainable, the heat dissipation of the semiconductor device is also facilitated to increase the reliability of the semiconductor device.

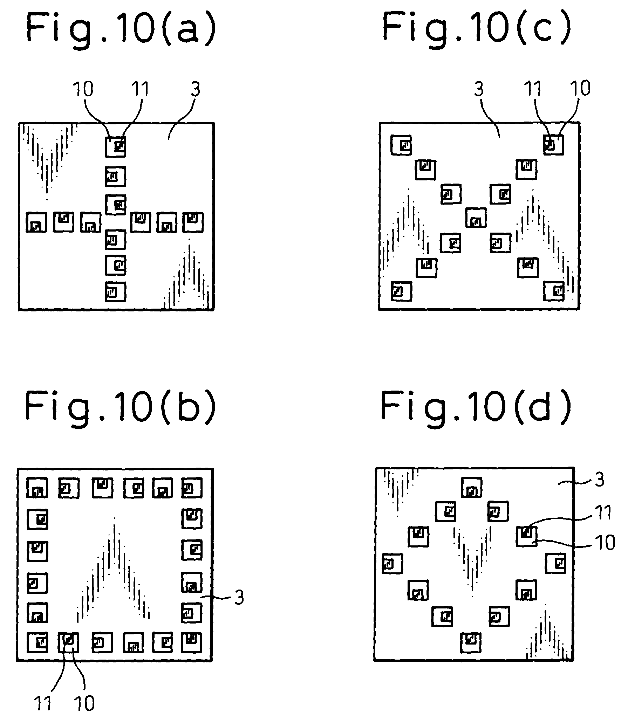

Figs. 10(a) to 10(d) show various layouts of the slits 10 and the inserts 11 in the die-pad section 3. The slits 10 and the inserts 11 may be arranged in a random manner, but are preferably arranged in a cross shape as shown in Fig. 10(a), in a square shape as shown in Fig. 10(b), in an X-shape as shown in Fig. 10(c) and in a diamond shape as shown in Fig. 10(d). In this connection, to strengthen the locked state of the shield resin, the inserts 11 formed in the adjacent slits 10 are preferably arranged in different directions such as, for example, in a zigzag manner.

As described above with reference to the preferred embodiments, the present invention should not be limited to the above-mentioned embodiments, but it can include various changes and modifications without departing from the spirit of the present invention. For example, the shape of the slit 10 and the layout on the die-pad 3 may be optionally variable.

According to the lead frame of the present invention, since a plurality of slits are formed in the die-pad section on which a semiconductor element is to be mounted and each has an insert coupled to the die-pad section by a proximal end thereof and defining a free end directed toward the slit at a distal end thereof, the thickness of the insert being smaller than that of the remainder of the die-pad section, it is possible to improve the flatness of the die-pad section when the slits and the inserts are formed in the die-pad section by press working or etching. Also, since a special installation for correcting a warp of the die-pad section is unnecessary, it is possible to lower the production cost of the lead frame.

Also, when the semiconductor device is produced while using the above-mentioned lead frame, the shield resin filled in the slits of the die-pad section is hardened while the inserts are embedded therein and firmly locked to the die-pad section. Therefore, a favorable bonding strength is maintained against thermal stress applied to the semiconductor device. The contact between the die-pad section and the shield resin is significantly facilitated and a sufficient area of the die-pad section is obtainable, whereby it is possible to favorably maintain the heat dissipation of the semiconductor device to improve the reliability of the semiconductor device.

## Claims

1. A lead frame (1) adapted to be used for a resin-shielded type semiconductor device, said lead frame comprising:
a die-pad section (3) on which a semiconductor element is to be mounted, said die-pad section (3) comprising a base die-pad section (3), a plurality of slits (10) and a plurality of inserts (11);
each of said inserts (11) having a proximal end integrally connected to said base die-pad section (3) and a distal end (11b) facing to said slit (10), said insert (11) having a thickness smaller than that of said base die-pad section (3).

2. A lead frame according to claim 1, wherein two of said inserts (11) respectively facing two of said slits (10) which are located adjacent to each other are directed in opposite directions to each other.

3. A lead frame according to claim 1 or 2, wherein said slits (10) are formed by punching or etching said die-pad section and said inserts (11) are formed by pressing so as to reduce their thickness.

4. A lead frame according to claim 1 or 2, wherein said slits (10) are formed by punching or etching said die-pad section and said inserts (11) are formed by etching so as to reduce their thickness.

5. A lead frame according to any one of the preceding claims, wherein said base die-pad section (3) has a first and second surface, a semiconductor element is to be mounted on said first surface, and said insert (11) has first and second surfaces, the thickness of said insert is reduced in such a manner that a gap is formed between said first surface of the die-pad section (3) and said first surface of the insert (11) and, on the other hand, said second surface of the die-pad section (3) and said second surface of the insert (11) are on substantially the same level.

6. A lead frame according to claim 5, wherein both said first and second surface of the base die-pad section (3) are coated with resist films (16), respectively.

7. A semiconductor device comprising:
a lead frame (1) in accordance with any one of the preceding claims, having a plurality of inner leads (4);
a semiconductor element (2) having a plurality of electrodes, said semiconductor element (2) being mounted on said die-pad section (3) of the lead frame (1) and the electrodes being electrically connected to said inner leads (4); and,
shield resin (9) hermetically shielding said semiconductor element (2) and said inner leads (4) in such a manner that said slits (10) are filled with said shield resin (9) and said inserts (11) are embedded in said shield resin (9).

8. A semiconductor device according to claim 7, wherein a gap is formed between a surface of the die-pad section (3) carrying the semiconductor element and a corresponding surface of the insert (11) and said gap is filled with said shield resin (9).
